# FASCICULE DE BREVET EUROPEEN

(11) **EP 2 997 598 B1**
(45) Date de publication et mention de la délivrance du brevet: **15.02.2017**
(21) Numéro de dépôt: 14729420.1
(22) Date de dépôt: 13.05.2014
(51) Int. Cl.: H01L 27/15, H01L 33/18, H01L 33/32, B82Y 20/00, H01L 33/00, H01L 33/08, H01L 33/14, H01L 33/24

(54) **DISPOSITIF OPTOÉLECTRONIQUE ET SON PROCÉDÉ DE FABRICATION**
OPTOELEKTRONISCHE VORRICHTUNG UND HERSTELLUNGSVERFAHREN DAFÜR
OPTOELECTRONIC DEVICE AND METHOD OF MANUFACTURING THE SAME

(30) Priorité: 14.05.2013 FR 1354286
(43) Date de publication de la demande: 23.03.2016
(73) Titulaire: Aledia, 38040 Grenoble Cedex (FR); Commissariat à l'Energie Atomique et aux Energies Alternatives, 75015 Paris (FR)
(72) Inventeur: GILET, Philippe, F-38470 Teche (FR); TCHELNOKOV, Alexei, F-38240 Meylan (FR); ROBIN, Ivan-Christophe, F-38000 Grenoble (FR)
(74) Mandataire: Thibon, Laurent
(86) Numéro de dépôt international: PCT/FR2014/051110
(87) Numéro de publication internationale: WO 2014/184486

(56) Documents cités:
- WO-A1-2009/072631
- WO-A1-2012/136665
- US-A- 4 439 910
- US-A- 5 283 447
- US-A1- 2012 001 303
- CHEN X ET AL: "Homoepitaxial growth of catalyst-free GaN wires on N-polar substrates", APPLIED PHYSICS LETTERS, AMERICAN INSTITUTE OF PHYSICS, US, vol. 97, no. 15, 13 octobre 2010 (2010-10-13), pages 151909-151909, XP012137241, ISSN: 0003-6951, DOI: 10.1063/1.3497078

## Description

La présente demande de brevet revendique la priorité de la demande de brevet français FR13/54286.

### Domaine

La présente invention concerne de façon générale les matériaux semiconducteurs, les dispositifs à base de matériaux semiconducteurs et leurs procédés de fabrication. La présente invention concerne plus particulièrement les dispositifs comprenant des éléments tridimensionnels, notamment des microfils ou nanofils semiconducteurs.

### Exposé de l'art antérieur

Des exemples de microfils ou nanofils comprenant un matériau semiconducteur sont les microfils ou nanofils à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI. De tels microfils ou nanofils permettent la fabrication de dispositifs semiconducteurs tels que des dispositifs optoélectroniques.

Par dispositifs optoélectroniques, on entend des dispositifs adaptés pour effectuer la conversion d'un signal électrique en un rayonnement électromagnétique ou inversement, et notamment des dispositifs dédiés à la détection, la mesure ou l'émission d'un rayonnement électromagnétique.

L'intégration de divers transistors (bipolaires, à effet de champ, etc.) avec des diodes laser à cavité verticale émettant par la surface (VCSELs, acronyme anglais pour Vertical-Cavity Surface Emitting Lasers) est connue, par exemple, du document de l'art antérieur: US 5 283 447 A.

L'intégration monolithique d'un transistor bipolaire avec une diode électroluminescente (LED, acronyme anglais pour Light Emitting Diode) ou avec une diode laser (LD, acronyme anglais pour Laser Diode) est connue, par ailleurs, du document de l'art antérieur: US 4 439 910 A.

Plus récemment enfin, des nanofils semiconducteurs à base de nitrure de gallium (GaN) et destinés à typiquement former une diode électroluminescente sont connus, par exemple, du document de l'art antérieur: WO 2012/136665 A1.

### Résumé

Ainsi, la présente invention concerne un dispositif optoélectronique comprenant :
un substrat semiconducteur dopé d'un premier type de conductivité ;
des plots ou une couche, en contact avec une face du substrat, dopés , respectivement dopée, d'un second type de conductivité opposé au premier type ;
des éléments semiconducteurs filaires, coniques ou tronconiques, dopés du premier type de conductivité, chaque élément étant en contact avec l'un des plots ou avec la couche ;
des portions semiconductrices électroluminescentes, chaque portion recouvrant au moins partiellement l'un des éléments semiconducteurs ; et
un circuit de polarisation des plots ou de la couche; dispositif dans lequel le substrat est en un matériau semiconducteur choisi dans le groupe comprenant le silicium, le germanium, le carbure de silicium, un composé III-V, un composé II-VI et une combinaison de ces composés, et dans lequel les plots ou la couche sont/est en un matériau choisi dans le groupe comprenant le nitrure d'aluminium, le nitrure de bore, le carbure de silicium, le nitrure de magnésium, le nitrure de gallium et de magnésium, ou en une combinaison de ceux-ci et de leurs composés nitrurés.

Selon un mode de réalisation, le dispositif comprend, en outre, un circuit de polarisation des portions semiconductrices.

Selon un mode de réalisation, la concentration de dopants des plots ou de la couche est comprise entre 10¹⁵ atomes/cm³ et 10¹⁹ atomes/cm³.

Selon un mode de réalisation, la concentration de dopants du substrat est comprise entre 10¹⁶ atomes/cm³ et 10²¹ atomes/cm³.

Selon un mode de réalisation, la concentration de dopants de chaque élément est comprise entre 10¹⁶ atomes/cm³ et 10²¹ atomes/cm³.

Selon un mode de réalisation, l'épaisseur de chaque plot ou de la couche est comprise entre 1 nm et 1 µm.

Selon un mode de réalisation, le substrat est en silicium monocristallin.

Selon un mode de réalisation, chaque élément comprend majoritairement un matériau semiconducteur choisi dans le groupe comprenant un composé III-V, un composé II-VI et une combinaison de ces composés.

Selon un mode de réalisation, chaque élément semiconducteur est un microfil ou un nanofil.

Selon un mode de réalisation, chaque élément semiconducteur est au moins partiellement recouvert de l'une des portions semiconductrices électroluminescentes.

Un mode de réalisation prévoit un procédé de fabrication du dispositif optoélectronique selon la présente invention, comprenant les étapes successives suivantes :
fournir un substrat semiconducteur dopé d'un premier type de conductivité ;
former, en contact avec une face du substrat, une couche dopée ou des plots dopés d'un second type de conductivité opposé au premier type ;
former des éléments semiconducteurs filaires, coniques ou tronconiques, dopés du premier type de conductivité, chaque élément semiconducteur étant en contact avec l'un des plots ou avec la couche ;
former des portions semiconductrices électroluminescentes, chaque portion recouvrant au moins partiellement l'un des éléments semiconducteurs ; et
fournir un circuit de polarisation des plots ou de la couche,
dans lequel le substrat est en un matériau semiconducteur choisi dans le groupe comprenant le silicium, le germanium, le carbure de silicium, un composé III-V, un composé II-VI et une combinaison de ces composés, et dans lequel les plots ou la couche sont/est en un matériau choisi dans le groupe comprenant le nitrure d'aluminium, le nitrure de bore, le carbure de silicium, le nitrure de magnésium, le nitrure de gallium et de magnésium, ou en une combinaison de ceux-ci et de leurs composés nitrurés.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un exemple d'un dispositif optoélectronique à microfils ou nanofils ne définissant pas, à lui seul, la présente invention ;
les figures 2 et 3 représentent des courbes d'évolution de l'intensité du courant traversant chaque microfil ou nanofil du dispositif optoélectronique de la figure 1 en fonction de la tension de polarisation entre les électrodes du dispositif ;
la figure 4 représente un circuit électrique équivalent d'une partie d'un mode de réalisation d'un dispositif optoélectronique à microfils ou nanofils en accord avec la présente invention ;
la figure 5 est une coupe, partielle et schématique, d'un mode de réalisation d'un dispositif optoélectronique , selon la présente invention, correspondant au circuit électrique équivalent de la figure 4 ;
les figures 6 et 7 représentent des courbes d'évolution de l'intensité du courant traversant chaque microfil ou nanofil du dispositif optoélectronique de la figure 5 en fonction de la tension de polarisation entre les électrodes du dispositif ;
les figures 8A à 8H sont des coupes, partielles et schématiques, des structures obtenues à des étapes successives d'un mode de réalisation d'un procédé de fabrication du dispositif optoélectronique de la figure 5 ; et
la figure 9 est une coupe, partielle et schématique, d'un autre mode de réalisation d'un dispositif optoélectronique à microfils ou nanofils selon la présente invention.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente invention concerne la fabrication d'éléments tridimensionnels, par exemple de microfils, de nanofils ou d'éléments de forme conique, notamment un cône pyramidal, ou tronconique. Dans la suite de la description, des modes de réalisation sont décrits pour la fabrication de microfils ou de nanofils. Toutefois, ces modes de réalisation peuvent être mis en oeuvre pour la fabrication d'éléments tridimensionnels autres que des microfils ou des nanofils, par exemple pour la fabrication d'éléments tridimensionnels de forme conique, notamment en forme de pyramide, ou de forme tronconique.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

La section droite des fils peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil.

Les fils peuvent être, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Dans certains modes de réalisation, les fils peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

Une couche de germination ou des plots ou îlots, appelés également par la suite îlots de germination, sont formés sur une face d'un substrat. La couche de germination ou les îlots de germination sont en un matériau favorisant la croissance des fils. Dans le cas d'îlots de germination, un traitement est, en outre, prévu pour protéger les flancs latéraux des îlots de germination et la surface des parties du substrat non recouvertes par les îlots de germination pour empêcher la croissance des fils sur les flancs latéraux des îlots de germination et sur la surface des parties du substrat non recouvertes par les îlots de germination. Le traitement peut comprendre la formation d'une région diélectrique sur les flancs latéraux des îlots de germination et s'étendant sur et/ou dans le substrat et reliant, pour chaque paire d'îlots, l'un des îlots de la paire à l'autre îlot de la paire, les fils ne croissant pas sur la région diélectrique.

Selon l'exemple qui suit, le substrat peut correspondre à une structure monobloc ou correspondre à une couche recouvrant un support constitué d'un autre matériau. Selon la présente invention, le substrat est en un matériau semiconducteur, tel qu'un substrat en silicium, en germanium, en carbure de silicium, en un composé III-V, tel que du GaN ou du GaAs, en un composé II-VI, tel que du ZnO, ou une combinaison de ces composés. Selon la présente invention, le substrat peut être en silicium monocristallin.

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

Le matériau constituant la couche de germination ou les îlots de germination est choisi de façon à favoriser la croissance des fils selon la même polarité. A titre d'exemple, lorsque les fils comprennent majoritairement un composé III-V, le matériau constituant les îlots de germination est choisi de préférence de façon à favoriser la croissance du composé III-V selon la polarité de l'élément du groupe V. Le composé III-V croît alors selon la polarité de l'élément du groupe V sur les îlots de germination, depuis le sommet de chaque îlot de germination, et ne croît ni sur les flancs latéraux des îlots de germination ni sur le reste du substrat. En outre, les inventeurs ont mis en évidence que chaque fil croît alors selon une polarité sensiblement constante dans la totalité du fil. Lorsque les fils comprennent majoritairement un composé II-VI, le matériau constituant les îlots de germination est choisi de préférence de façon à favoriser la croissance du composé II-VI selon la polarité de l'élément du groupe VI. Le composé II-VI croît alors selon la polarité de l'élément du groupe VI sur les îlots de germination, depuis le sommet de chaque îlot de germination, et ne croît ni sur les flancs latéraux des îlots de germination ni sur le reste du substrat.

Dans le cas d'un composé III-V dans lequel l'élément du groupe V est l'azote, le matériau composant les îlots peut être un matériau favorisant la croissance d'un fil selon la polarité N. A titre d'exemple, et également selon la présente invention, les îlots (plots) sont réalisés en nitrure d'aluminium (AlN), en nitrure de bore (BN), en carbure de silicium (SiC), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), ou en une combinaison de ceux-ci et de leurs composés nitrurés. De préférence, le matériau composant les îlots de germination est le nitrure d'aluminium.

Le procédé de croissance des fils peut être un procédé du type dépôt chimique en phase vapeur (CVD, sigle anglais pour Chemical Vapor Deposition) ou dépôt chimique en phase vapeur organométallique (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Deposition), les procédés hydrothermiques, la pyrolise d'aérosol liquide ou l'électrodépôt.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), la tertiarybutylphosphine (TBP), l'arsine (AsH₃), ou la diméthylhydrazine asymétrique (UDMH).

Selon un mode de réalisation de l'invention, telle que définie par les présentes revendications, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).

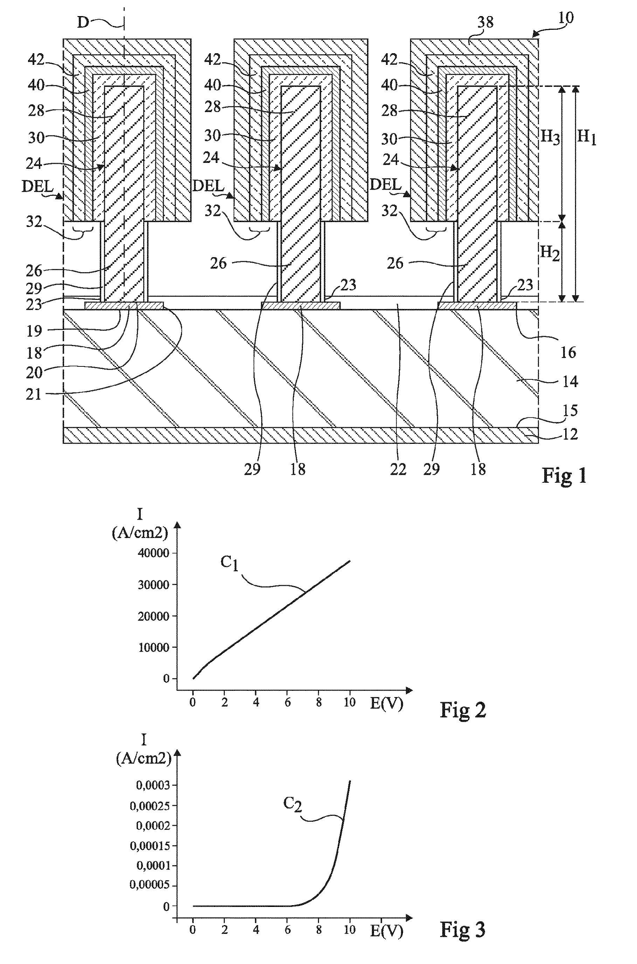

La figure 1 est une coupe, partielle et schématique, d'un exemple d'un dispositif optoélectronique 10 réalisé à partir de fils tels que décrits précédemment et adapté à l'émission d'un rayonnement électromagnétique.

Le dispositif 10 comprend, du bas vers le haut en figure 1 :
une première électrode de polarisation 12 ;
un substrat semiconducteur 14 comprenant des faces opposées 15 et 16, la face 15 étant au contact de l'électrode 12 ;
des îlots de germination 18 favorisant la croissance de fils et disposés sur la face 16, chaque îlot 18 comprenant une face inférieure 19 en contact avec la face 16 du substrat 14, une face supérieure 20, opposée à la face 19, et à distance de la face 19 et des faces latérales 21, ou flancs latéraux, reliant la face inférieure 19 à la face supérieure 20 ;
une couche isolante 22 s'étendant entre les îlots de germination 18 sur la face 16 du substrat 14, la couche isolante 22 recouvrant partiellement chaque îlot de germination 18 et comprenant des ouvertures 23 qui exposent chacune une partie du sommet 20 de l'un des îlots de germination 18 ;
des fils 24 (trois fils étant représentés) de hauteur H₁, chaque fil 24 étant en contact avec la face 20 de l'un des îlots 18, chaque fil 24 comprenant une portion inférieure 26, de hauteur H₂, en contact avec l'îlot 18 et une portion supérieure 28, de hauteur H₃, en contact avec la portion inférieure 26 ;
une couche passivante 29 recouvrant la périphérie de chaque portion inférieure 26 ;
une couche active 30 recouvrant chaque portion supérieure 28 ;
une couche semiconductrice 32 ou un empilement de couches semiconductrices recouvrant chaque couche active 30 ; et
une couche de seconde électrode 38 recouvrant chaque couche semiconductrice 32.

L'ensemble formé par chaque fil 24, et l'empilement de la couche active 30, des couches semiconductrices 32 et de l'électrode 38 forme une diode électroluminescente DEL.

Le substrat 14 est, par exemple, un substrat semiconducteur, tel qu'un substrat en silicium. Le substrat 14 est dopé d'un premier type de conductivité, par exemple dopé de type N. Les faces 15 et 16 peuvent être planes et parallèles. La face 16 du substrat 14 peut être une face <100>.

L'électrode 12 peut correspondre à une couche conductrice qui s'étend sur la face 15 du substrat 14. Le matériau formant l'électrode 12 est, par exemple, du siliciure de nickel (NiSi), de l'aluminium (Al), du siliciure d'aluminium (AlSi), du titane (Ti) ou du siliciure de titane (TiSi). Cette couche peut être recouverte d'une autre couche métallique, par exemple de l'or, du cuivre ou des eutectiques (Ti/Ni/Au ou Sn/Ag/Cu) en cas de brasure.

Les îlots 18 sont situés sur la face 16 de sorte qu'ils soient en saillie par rapport à la face 16. Le sommet 20 de chaque îlot 18 est donc dans un plan différent de la face 16. Chaque îlot 18 a une texturation préférentielle et, lorsque le matériau composant chaque îlot comprend un alliage d'au moins deux éléments, une polarité préférentielle. Par texturation préférentielle, on entend que les cristaux qui composent les îlots 18 ont une direction de croissance privilégiée qui est la même pour tous les îlots 18. Par polarité préférentielle, on entend que les îlots 18 ont sensiblement tous la même polarité. Ceci signifie que lorsque le matériau composant chaque îlot comprend un alliage d'au moins deux éléments, lorsque le matériau est coupé dans un plan perpendiculaire à la direction de croissance privilégiée du matériau, la surface exposée comprend essentiellement des atomes du même élément pour chaque îlot 18. Chaque îlot 18 présente le même type de conductivité, par exemple de type N, que le substrat 14 afin de réduire la résistance d'interface entre les îlots 18 et le substrat 14. Chaque îlot 18 peut avoir une forme quelconque, par exemple rectangulaire, polygonale, circulaire, carrée ou ovale.

Les îlots 18 ont, par exemple, une épaisseur comprise entre 1 et 100 nanomètres, de préférence comprise entre 1 et 60 nanomètres, plus préférentiellement entre 1 nm et 10 nm, encore plus préférentiellement entre 2 nm et 5 nm. Les centres de deux îlots 18 adjacents peuvent être distants de 0,5 µm à 10 µm et de préférence de 1,5 à 4 µm. A titre d'exemple, les îlots 18 peuvent être régulièrement répartis sur le substrat 14. A titre d'exemple, les îlots 18 peuvent être répartis selon un réseau hexagonal.

La couche isolante 22 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxyde d'aluminium (Al₂O₃), en oxyde d'hafnium (HfO₂) ou en diamant. L'épaisseur de la couche isolante 22 est strictement supérieure à l'épaisseur des îlots de germination 18. A titre d'exemple, l'épaisseur de la couche isolante 22 est comprise entre 5 nm et 500 nm, par exemple égale à environ 30 nm.

Chaque fil 24 a une structure semiconductrice allongée selon un axe D sensiblement perpendiculaire à la face 16. Chaque fil 24 peut avoir une forme générale cylindrique allongée à base hexagonale. Le diamètre moyen de chaque fil 24 peut être compris entre 50 nm et 2,5 µm et la hauteur H₁ de chaque fil 24 peut être comprise entre 250 nm et 50 µm.

La portion inférieure 26 de chaque fil 24 est principalement constituée du composé III-N, par exemple du nitrure de gallium, dopé du premier type de conductivité, par exemple au silicium. Le pourtour de la portion inférieure 26 est recouvert par la couche 29 de diélectrique, par exemple du SiN, sur la hauteur H₂ depuis l'extrémité de la portion inférieure 26 au contact avec l'îlot 18 associé. La hauteur H₂ peut être comprise entre 100 nm et 25 µm. La couche de matériau diélectrique 29 a une épaisseur comprise entre une monocouche atomique et 100 nm, de préférence entre une monocouche atomique et 10 nm.

La portion supérieure 28 de chaque fil 24 est, par exemple, au moins partiellement réalisée dans un composé III-N, par exemple du GaN. La portion supérieure 28 peut être dopée du premier type de conductivité, ou ne pas être intentionnellement dopée. La portion supérieure 28 s'étend sur la hauteur H₃ qui peut être comprise entre 100 nm et 25 µm.

Dans le cas d'un fil composé principalement de GaN, la structure cristalline du fil peut être du type wurtzite, le fil s'étendant selon l'axe C. La structure cristalline du fil peut également être du type cubique.

La couche active 30 est la couche depuis laquelle est émise la majorité du rayonnement fourni par le dispositif 10. Selon un exemple, la couche active 30 peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche semiconductrice 32 ou l'empilement de couches semiconductrices 32 permet la formation d'une jonction P-N ou PI-N avec la couche active 30 et/ou la portion supérieure 28. Elle permet l'injection de trous dans la couche active 30 via l'électrode 38.

L'empilement de couches semiconductrices 32 peut comprendre une couche de blocage d'électrons 40 formée d'un alliage ternaire, par exemple en nitrure de gallium et d'aluminium (AlGaN) ou en nitrure d'indium et d'aluminium (AlInN) en contact avec la couche active 30 et une couche supplémentaire 42, pour assurer un bon contact électrique entre la deuxième électrode 38 et la couche active 30, par exemple en nitrure de gallium (GaN) en contact avec la couche de blocage d'électrons 40 et avec l'électrode 38. La couche semiconductrice 42 est dopée du type de conductivité opposé à celui de la portion 28, par exemple dopée de type P. La couche de blocage d'électrons 40 peut être de même type de conductivité que la couche semiconductrice 42.

La deuxième électrode 38 est adaptée pour polariser la couche active 30 de chaque fil 24 et laisser passer le rayonnement électromagnétique émis par les fils 24. Le matériau formant l'électrode 38 peut être un matériau transparent et conducteur tel que de l'oxyde d'indium-étain (ou ITO, acronyme anglais pour Indium Tin Oxide), de l'oxyde de zinc dopé à l'aluminium ou du graphène.

Dans le présent exemple, les fils 24 sont réalisés sur des îlots 18 qui sont des éléments séparés répartis sur le substrat 14. A titre de variante, les îlots de germination 18 peuvent être remplacés par une couche de germination recouvrant la face 16 du substrat 14. La couche de germination peut être recouverte d'une couche isolante comprenant des ouvertures qui exposent des portions de la couche de germination, les fils croissant sur les portions exposées de la couche de germination.

Les îlots de germination 18, ou la couche de germination, doivent satisfaire plusieurs contraintes.

Premièrement, les îlots de germination 18 ou la couche de germination doivent permettre la croissance des fils 24.

Deuxièmement, les îlots de germination 18 ou la couche de germination doivent empêcher la diffusion de l'élément du groupe III, notamment le gallium, depuis chaque fil 24 vers le substrat 14. En effet, la diffusion de l'élément du groupe III dans le substrat 14 entraînerait la création d'un alliage de silicium et de l'élément du groupe III qui est néfaste pour l'obtention de matériaux de bonne qualité pour la réalisation d'un dispositif optoélectronique.

Troisièmement, les îlots de germination 18 ou la couche de germination doivent permettre le passage d'un courant entre chaque fil 24 et le substrat 14 lorsque les électrodes 12 et 38 sont polarisées de façon convenable. Toutefois, les matériaux utilisés actuellement pour la réalisation des îlots de germination 18 ou de la couche de germination ont généralement des propriétés isolantes. C'est le cas du nitrure d'aluminium (AlN). L'épaisseur de chaque îlot de germination 18 ou de la couche de germination doit donc être suffisamment faible pour que les électrons puissent la traverser par effet tunnel. Dans ce but, l'épaisseur de chaque îlot de germination 18 ou de la couche de germination est de façon générale inférieure à 2 nm.

La figure 2 représente une courbe C₁ d'évolution de l'intensité du courant par unité de surface (A/cm²) traversant des îlots de germination 18 d'épaisseur 1 nm en fonction de la tension appliquée entre les électrodes 38 et 12. La courbe C₁ a été obtenue avec un substrat 14 de silicium dopé de type N avec une concentration de dopants de 10¹⁹ atomes/cm³, avec des îlots de germination de AlN dopés de type N avec une concentration de dopants de 10¹⁷ atomes/cm³. La courbe C₁ met en évidence le passage d'un courant au travers des îlots de germination 18.

La figure 3 représente une courbe C₂ d'évolution de l'intensité du courant par unité de surface (A/cm²) traversant des îlots de germination 18, obtenue pour un dispositif optoélectronique identique à celui qui a été utilisé pour obtenir la courbe C₁ de la figure 2 à la différence que l'épaisseur de chaque îlot de germination 18 est d'environ 5 nm. Comme cela apparaît en figure 3, lorsque l'épaisseur des îlots de germination 18 est trop importante, il n'est pas observé de passage de courant au travers des îlots de germination 18 pour une tension de polarisation inférieure à 10 V.

Le passage par effet tunnel des électrons au travers des îlots de germination 18 est favorisé lorsque le substrat 14, les îlots de germination 18, et les portions inférieures 26 des fils 24 sont fortement dopés au moins au niveau des interfaces entre ces régions. Toutefois, lorsque les îlots de germination 18 sont en AlN, de l'aluminium peut diffuser vers le substrat en silicium 14. L'aluminium est un dopant de type P pour le silicium. De ce fait, la diffusion de l'aluminium dans le substrat 14 tend à diminuer la valeur du dopage de type N du substrat 14 au niveau de l'interface entre le substrat 14 et les îlots de germination 18. L'amélioration du passage par effet tunnel des électrons au travers des îlots de germination 18 due à l'augmentation des concentrations de dopants de type N n'est alors pas obtenue.

Ainsi, un objet d'un mode de réalisation est de pallier au moins en partie les inconvénients des dispositifs optoélectroniques, notamment à microfils ou nanofils, et de leurs procédés de fabrication décrits précédemment.

Un autre objet d'un mode de réalisation est d'améliorer le passage du courant au travers de chaque îlot de germination ou de la couche de germination.

Un autre objet d'un mode de réalisation est que chaque élément tridimensionnel, notamment chaque fil, en matériau semiconducteur ait sensiblement une structure monocristalline.

Un autre objet d'un mode de réalisation est que la position, la géométrie et les propriétés cristallographiques de chaque élément tridimensionnel, notamment chaque fil, en matériau semiconducteur puissent être contrôlées de façon précise et uniforme.

Un autre objet d'un mode de réalisation est que les éléments tridimensionnels, notamment les fils, en matériau semiconducteur puissent être formés à une échelle industrielle et à bas coût.

Selon un mode de réalisation, on prévoit de doper le substrat semiconducteur et au moins la portion inférieure des fils avec des dopants d'un premier type de conductivité, de doper les îlots de germination ou la couche de germination avec des dopants d'un deuxième type de conductivité, opposé au premier type de conductivité, et de relier les îlots de germination ou la couche de germination à une source de polarisation, par exemple une source de courant ou de tension. Chaque îlot de germination ou la couche de germination peut jouer le rôle de la base d'un transistor bipolaire en série avec chaque diode électroluminescente.

Un avantage est que l'épaisseur des îlots de germination ou de la couche de germination peut être augmentée et que la concentration de dopants des îlots de germination ou de la couche de germination peut être diminuée.

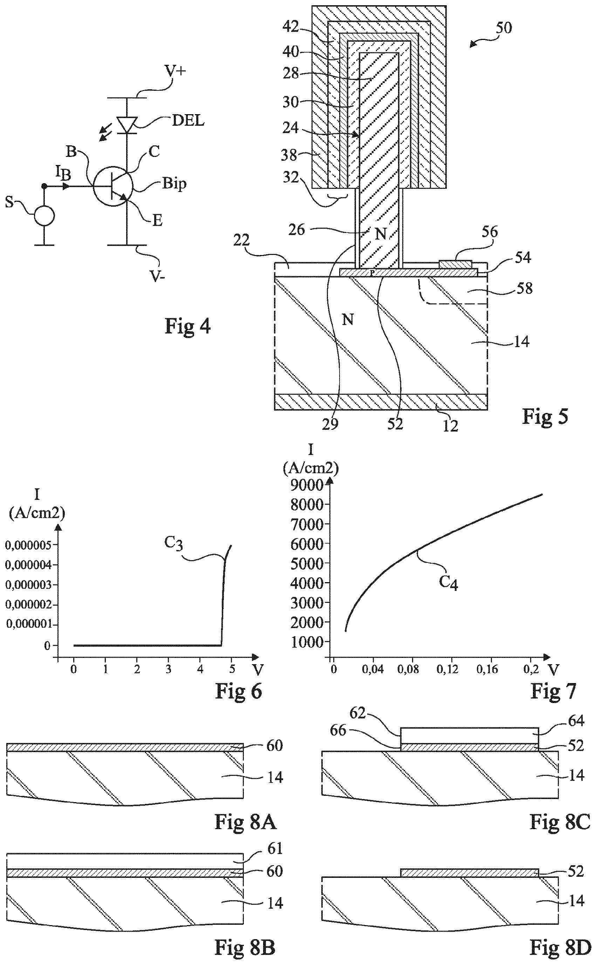

La figure 4 représente un schéma électrique équivalent en fonctionnement associé à une diode électroluminescente DEL d'un mode de réalisation d'un dispositif optoélectronique selon la présente invention. Les sources de potentiel V+ et V- correspondent aux sources de potentiel destinées à être reliées, en fonctionnement, aux électrodes 12 et 38. Le collecteur C du transistor bipolaire Bip est connecté à la cathode de la diode DEL, l'émetteur E du transistor Bip est connecté à la source de tension V- et la base B est connectée à une source de courant S. A titre de variante, la polarisation de la base B peut être réalisée par tout type de circuit de polarisation, notamment par une source de tension en série avec une résistance ou par un pont diviseur de tension prévu entre les sources de potentiel V+ et V-.

En fonctionnement, la base B du transistor est, de préférence, polarisée de façon que le transistor bipolaire fonctionne en régime de saturation. Ceci permet avantageusement de rendre maximal le courant traversant la diode DEL.

La figure 5 est une coupe, partielle et schématique, d'un mode de réalisation selon l'invention d'un dispositif optoélectronique 50 réalisé à partir de fils tels que décrits précédemment, adapté à l'émission d'un rayonnement électromagnétique et pour lequel le schéma électrique équivalent associé à chaque fil est représenté en figure 4.

Le dispositif optoélectronique 50 comprend l'ensemble des éléments du dispositif optoélectronique 10 décrit précédemment en relation avec la figure 1 à la différence que chaque îlot de germination 18 du dispositif optoélectronique 10, qui a le même type de dopants que le substrat 14 et la portion inférieure 26 du fil 24, est remplacé par un îlot de germination (plot) 52 ayant un type de dopants opposé au type de dopants du substrat 14 et de la portion inférieure 26 du fil 24. De ce fait, si le substrat 14 et la portion inférieure 26 sont dopés de type N, l'îlot de germination 52 est dopé de type P. Les matériaux constituant l'îlot de germination 52 peuvent être identiques à ceux décrits précédemment pour l'îlot de germination 18.

A titre d'exemple, l'épaisseur de chaque îlot de germination 52 est comprise entre 1 nm et 1 µm, de préférence entre 1 et 500 nm, de préférence entre 10 nm et 200 nm, plus préférentiellement entre 100 nm et 200 nm.

A titre d'exemple, la concentration de dopants de l'îlot de germination 52 est comprise entre 10¹⁵ et 10¹⁹ atomes/cm³, de préférence inférieure à 10¹⁸ atomes/cm³. A titre d'exemple, la concentration de dopants du substrat 14 est comprise entre 10¹⁷ et 10²¹ atomes/cm³ et la concentration de dopants de la portion inférieure 26 du fil est comprise entre 10¹⁷ et 10²¹ atomes/cm³.

Chaque îlot de germination 52 peut comprendre une portion 54 s'étendant latéralement. Un plot conducteur 56 peut être prévu au contact de la portion 54. Le plot conducteur 56 est destiné à être relié au circuit de polarisation S. Une région 58 réalisée, par exemple, par implantation de protons ou par dopage avec des niveaux profonds, peut être prévue sous la portion 54 de l'îlot de germination 52 pour l'isoler du reste du substrat 14.

Le substrat 14 correspond à l'émetteur E du transistor bipolaire Bip, l'îlot de germination 52 correspond à la base B du transistor bipolaire Bip et la portion inférieure 26 du fil 24 correspond au collecteur C du transistor bipolaire Bip.

La figure 6 représente une courbe C₃ d'évolution de l'intensité du courant par unité de surface (A/cm²) traversant chaque fil 24 du dispositif optoélectronique 50 en fonction de la tension appliquée entre les électrodes 38 et 12. La courbe C₃ a été obtenue avec un substrat 14 de silicium dopé de type N avec une concentration de dopants de 10¹⁹ atomes/cm³, avec un îlot de germination 52 de AlN ayant une épaisseur de 100 nm et dopé de type P avec une concentration de dopants de 10¹⁷ atomes/cm³ et avec une portion inférieure 26 de fil 24 dopé de type N avec une concentration de dopants de 10¹⁸ atomes/cm³. La base du transistor bipolaire n'était pas alimentée en courant. La courbe C₃ met en évidence l'absence de passage d'un courant au travers des îlots de germination 18 au moins pour des tensions inférieures à 4 V.

La figure 7 représente une courbe C₄ d'évolution de l'intensité du courant par unité de surface (A/cm²) traversant des îlots de germination 18, obtenue pour un dispositif optoélectronique identique à celui qui a été utilisé pour obtenir la courbe C₃ de la figure 6 à la différence que la base B était reliée à une source d'une tension de 2,5 V, de sorte que le courant à base était de l'ordre de 1 A/cm². Comme cela apparaît en figure 7, le passage d'un courant dans le fil 24 a été observé dès que l'on applique une tension entre les électrodes 38 et 12 supérieure à quelques millivolts.

Les figures 8A à 8H illustrent les structures obtenues à des étapes successives d'un mode de réalisation d'un procédé de fabrication du dispositif optoélectronique 50 de la figure 5.

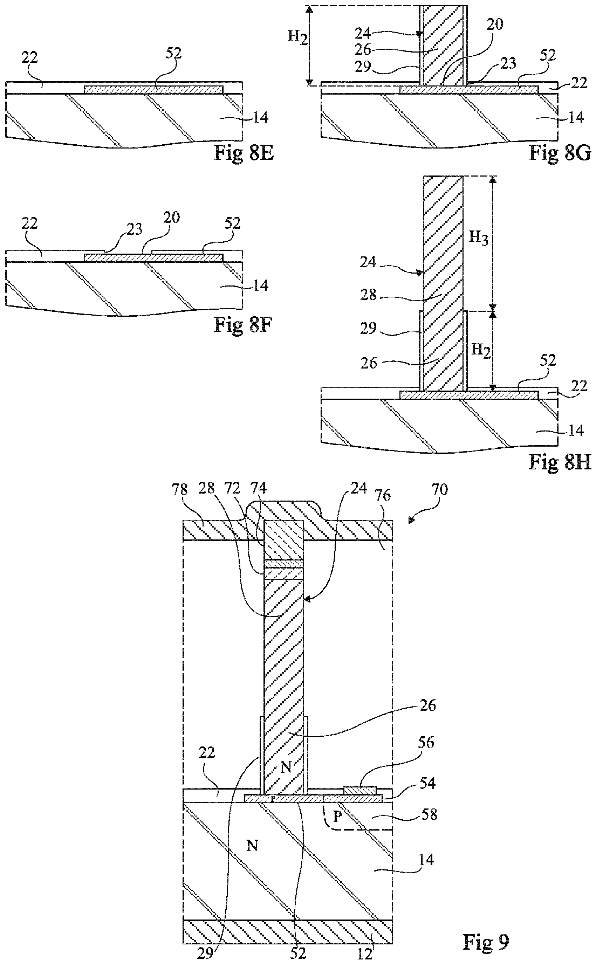

Le mode de réalisation du procédé de fabrication selon l'invention comprend les étapes suivantes :
(1) Dépôt sur le substrat 14 d'une couche 60 uniforme du matériau favorisant la croissance du composé III-N, par exemple selon la polarité N (figure 8A). Il peut s'agir de nitrure d'aluminium. La couche 60 a, par exemple, une épaisseur comprise entre 1 nm et 1 µm. La couche 60 peut être obtenue par un procédé du type MOCVD. Toutefois, des procédés tels que CVD, MBE, GSMBE, MOMBE, ALE, HVPE, ALD (acronyme anglais pour Atomic Layer Deposition), l'évaporation ou la pulvérisation cathodique réactive peuvent être utilisés ou tout type de dépôt permettant l'obtention d'une couche texturée. Lorsque la couche 60 est en nitrure d'aluminium, la couche 60 doit être sensiblement texturée et posséder une polarité préférentielle. La texturation de la couche 60 peut être obtenue par un traitement supplémentaire réalisé après le dépôt de la couche 60. Il s'agit, par exemple, d'un recuit sous flux d'ammoniac (NH₃). La couche 60 est dopée de type P. Le substrat 14 est dopé de type N au moins au niveau d'une région en contact avec la couche 60. De préférence, le substrat 14 est entièrement dopé de type N.
(2) Dépôt d'une couche 61 d'un matériau diélectrique sur la couche 60 (figure 8B). La couche 61 est en un matériau diélectrique qui peut être gravé de façon sélective par rapport au matériau formant la couche 60. Le matériau diélectrique est, par exemple, du nitrure de silicium (par exemple Si₃N₄). La couche diélectrique 61 a, par exemple, une épaisseur comprise entre 50 et 200 nm, par exemple environ 100 nm.
(3) Gravure d'ouvertures 62 dans la couche diélectrique 61 pour former des portions 64, ou blocs, de la couche diélectrique 61 et exposer des zones de la couche 60 et gravure d'ouvertures 66 dans la couche 60 au niveau des parties exposées de la couche 60 pour former les îlots 52 (figure 8C). La gravure des ouvertures 62 peut être réalisée par une étape de gravure sélective qui n'entraîne pas de gravure de la couche 60. Il peut s'agir d'une gravure utilisant un plasma d'hexafluorure de soufre (SF₆). La gravure des ouvertures 66 peut correspondre à une gravure sèche ou humide avec arrêt sur le substrat 14. A titre d'exemple, la gravure des ouvertures 66 peut être une gravure ionique réactive ou RIE (sigle anglais pour Reactive Ion Etching), une gravure au plasma couplé par induction ou gravure ICP (sigle anglais pour Inductively Coupled Plasma) ou une gravure humide.
(4) Retrait des portions 64 (figure 8D). Le retrait des portions 64 de la couche diélectrique peut être réalisé par une étape de gravure sélective qui n'entraîne pas de gravure des îlots 52 et du substrat 14. Il peut s'agir d'une gravure utilisant un plasma d'hexafluorure de soufre (SF₆) ou un plasma chloré, ou d'une gravure humide de type BOE (acronyme anglais pour Buffered Oxide Etch) utilisant un mélange de fluorure d'ammonium (NH₄F) et d'acide fluorhydrique (HF).
(5) Dépôt de la couche diélectrique 22 sur les îlots 52 et sur le substrat 14 (figure 8E). Il s'agit, de préférence, d'un dépôt conforme ou sensiblement conforme. La couche 22 est en un matériau diélectrique qui peut être gravé de façon sélective par rapport au matériau constituant les îlots 52 et le substrat 14. La couche 22 est, par exemple, en nitrure de silicium (par exemple Si₃N₄), en oxyde de silicium (SiO₂) ou en un siliciure des matériaux décrits précédemment pour la réalisation des îlots de germination 18. La couche 22 a, par exemple, une épaisseur supérieure d'au moins 5 nm à l'épaisseur des îlots de germination 18.
(6) Gravure des ouvertures 23 dans la couche 22 pour exposer une partie des sommets 20 des îlots 52 (figure 8F). Il s'agit d'une gravure sélective par rapport au matériau constituant les îlots de germination 52. Il s'agit, par exemple, d'une gravure ionique ou d'une gravure par ions réactifs.
(7) Croissance de la portion passivée 26 de chaque fil 24 sur la hauteur H₂ (figure 8G). Chaque fil 24 croît depuis la face 20 au sommet d'un îlot de germination 52. La portion inférieure 26 de chaque fil 24 peut être obtenue par un procédé du type MOCVD. Toutefois, des procédés tels que CVD, MBE, GSMBE, MOMBE, PAMBE, ALE, HVPE, ou électro-chimiques peuvent être utilisés.
   A titre d'exemple, dans le cas où la portion inférieure 26 est en GaN fortement dopé de type N, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950°C et 1100°C, de préférence entre 990°C et 1060°C. Pour transporter les espèces de la sortie des bulleurs aux deux plénums du réacteur, on utilise un flux de gaz porteur, par exemple du N₂, de 2000 sccm réparti dans les deux plénums. Les flux de gaz indiqués précédemment sont donnés à titre indicatif et sont à adapter en fonction de la taille et des spécificités du réacteur.
   La présence de silane parmi les gaz précurseurs entraîne l'incorporation de silicium au sein du composé GaN. On obtient ainsi une portion inférieure 26 dopée de type N. En outre, ceci se traduit par la formation de la couche 29 de nitrure de silicium qui recouvre le pourtour de la portion 26 de hauteur H₂, à l'exception du sommet au fur et à mesure de la croissance de la portion 26.
(8) Croissance de la portion supérieure 28 de hauteur H₃ de chaque fil 24 (figures 8H) sur le sommet de la portion inférieure 26. Pour la croissance de la portion supérieure 28, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, la portion supérieure 28 peut être dopée de type N en raison de la diffusion dans cette portion active de dopants provenant des portions passivées adjacentes ou en raison du dopage résiduel du GaN.

Le procédé comprend les étapes supplémentaires suivantes :
(9) Formation, pour chaque fil 24, de la couche active 30 par épitaxie. Compte tenu de la présence de la portion passivante 29 recouvrant le pourtour de la portion inférieure 26, le dépôt de la couche active 30 ne se produit que sur la portion supérieure 28 du fil 24 ;
(10) Formation par épitaxie, pour chaque fil 24, de la couche de blocage d'électrons 40 et de la couche semiconductrice 42 sur la couche active 30 ; et
(11) Formation des électrodes 38 et 12.

Le procédé de fabrication comprend, en outre, des étapes de formation du plot conducteur 56 qui peuvent être prévues avant les étapes de formation du fil 24 ou après celles-ci.

La figure 9 est une coupe, partielle et schématique, d'un autre mode de réalisation d'un dispositif optoélectronique 70, selon la présente invention, qui est adapté pour émettre un rayonnement électromagnétique. Le dispositif 70 diffère du dispositif 50 notamment par la forme de la portion active de chaque fil 24. En effet, pour chaque fil 24, la portion active 72 recouvre seulement le sommet du fil 24. La portion active 72 peut avoir la même composition que la couche active 30 décrite précédemment. En outre, un empilement de portions semiconductrices 74 recouvre la portion active 72. L'empilement de couches semiconductrices 74 peut avoir la même composition que l'empilement 32 décrit précédemment. Une portion isolante 76 recouvre le substrat 14 sensiblement jusqu'au sommet de l'empilement de portions semiconductrices 74. Une électrode 78, pouvant avoir la même composition que l'électrode 38 décrite précédemment, recouvre la portion isolante 76 et vient au contact de la couche au sommet de l'empilement de couches semiconductrices 74.

Des modes de réalisation particuliers de la présente invention ont été décrits. Diverses variantes et modifications apparaîtront à l'homme de l'art. En particulier, bien qu'on ait représenté sur les figures des modes de réalisation dans lesquels les fils, recouverts d'une première électrode, sont formés sur une première face d'un support tandis qu'une deuxième électrode est formée sur une deuxième face du support, opposée à la première face, il est clair que la deuxième électrode peut être prévue du côté de la première face.

De plus, bien que, dans les modes de réalisation décrits précédemment, chaque fil 24 comprenne une portion passivée 26, à la base du fil en contact avec le sommet 20 d'un îlot de germination 52, cette portion passivée 26 peut ne pas être présente.

En outre, bien que des modes de réalisation aient été décrits pour un dispositif optoélectronique comprenant des îlots de germination recouvrant un substrat, il est clair que le dispositif optoélectronique peut comprendre une couche de germination recouvrant le substrat, la couche de germination étant elle-même recouverte d'une couche isolante dans laquelle sont prévues des ouvertures pour exposer des parties de la couche de germination, les fils croissant dans les ouvertures. Dans ce cas, la couche de germination forme une base commune à tous les transistors bipolaires prévus en série avec les diodes électroluminescentes.

## Revendications

1. Dispositif optoélectronique (50 ; 70) comprenant :
un substrat (14) semiconducteur dopé d'un premier type de conductivité ;
des plots (52) ou une couche , en contact avec une face (16) du substrat, dopés, respectivement dopée, d'un second type de conductivité opposé au premier type ;
des éléments semiconducteurs filaires (24), coniques ou tronconiques, dopés du premier type de conductivité, chaque élément étant en contact avec l'un des plots ou avec la couche ;
des portions semiconductrices (30; 72) électroluminescentes, chaque portion recouvrant au moins partiellement l'un des éléments semiconducteurs ; et
un circuit (S) de polarisation des plots (52) ou de la couche,
dans lequel le substrat est en un matériau semiconducteur choisi dans le groupe comprenant le silicium, le germanium, le carbure de silicium, un composé III-V, un composé II-VI et une combinaison de ces composés et dans lequel les plots ou la couche sont/est en un matériau choisi dans le groupe comprenant le nitrure d'aluminium, le nitrure de bore, le carbure de silicium, le nitrure de magnésium, le nitrure de gallium et de magnésium, ou en une combinaison de ceux-ci et de leurs composés nitrurés.

2. Dispositif optoélectronique selon la revendication 1, comprenant, en outre, un circuit (V+, V-) de polarisation des portions semiconductrices (30; 72).

3. Dispositif optoélectronique selon la revendication 1 ou 2, dans lequel la concentration de dopants des plots (52) ou de la couche est comprise entre 10¹⁵ atomes/cm³ et 10¹⁹ atomes/cm³.

4. Dispositif optoélectronique selon l'une quelconque des revendications 1 à 3, dans lequel la concentration de dopants du substrat (14) est comprise entre 10¹⁶ atomes/cm³ et 10²¹ atomes/cm³.

5. Dispositif optoélectronique selon l'une quelconque des revendications 1 à 4, dans lequel la concentration de dopants de chaque élément semiconducteur (24) est comprise entre 10¹⁶ atomes/cm³ et 10²¹ atomes/cm³.

6. Dispositif optoélectronique selon l'une quelconque des revendications 1 à 5, dans lequel l'épaisseur de chaque plot (52) ou de la couche est comprise entre 1 nm et 1 µm.

7. Dispositif optoélectronique selon l'une quelconque des revendications 1 à 6, dans lequel le substrat (14) est en silicium monocristallin.

8. Dispositif optoélectronique selon l'une quelconque des revendications 1 à 7, dans lequel chaque élément semiconducteur (24) comprend majoritairement un matériau semiconducteur choisi dans le groupe comprenant un composé III-V, un composé II-VI et une combinaison de ces composés.

9. Dispositif optoélectronique selon l'une quelconque des revendications 1 à 8, dans lequel chaque élément semiconducteur (24) est un microfil ou un nanofil.

10. Dispositif optoélectronique selon l'une quelconque des revendications 1 à 9, dans lequel chaque élément semiconducteur (24) est au moins partiellement recouvert de l'une des portions semiconductrices (30; 72) électroluminescentes.

11. Procédé de fabrication du dispositif optoélectronique (50 ; 70) selon l'une quelconque des revendications 1 à 10, comprenant les étapes successives suivantes :
fournir un substrat (14) semiconducteur dopé d'un premier type de conductivité ;
former, en contact avec une face (16) du substrat, une couche dopée ou des plots (52) dopés d'un second type de conductivité opposé au premier type ;
former des éléments semiconducteurs filaires (24), coniques ou tronconiques, dopés du premier type de conductivité, chaque élément semiconducteur étant en contact avec l'un des plots ou avec la couche ;
former des portions semiconductrices (30; 72) électroluminescentes, chaque portion recouvrant au moins partiellement l'un des éléments semiconducteurs ; et
fournir un circuit (S) de polarisation des plots (52) ou de la couche,
dans lequel le substrat est en un matériau semiconducteur choisi dans le groupe comprenant le silicium, le germanium, le carbure de silicium, un composé III-V, un composé II-VI et une combinaison de ces composés et dans lequel les plots ou la couche sont/est en un matériau choisi dans le groupe comprenant le nitrure d'aluminium, le nitrure de bore, le carbure de silicium, le nitrure de magnésium, le nitrure de gallium et de magnésium, ou en une combinaison de ceux-ci et de leurs composés nitrurés.

## Patentansprüche

1. Eine optoelektronische Vorrichtung (50; 70), wobei die Vorrichtung Folgendes aufweist:
ein dotiertes Halbleitersubstrat (14) von einem ersten Leitungstyp;
Anschlüsse (52) oder eine Schicht auf einer Oberfläche (16) des Substrats, die mit einem zweiten Leitungstyp gegensätzlich zu dem ersten Typ dotiert sind;
drahtförmige (24), konische oder verjüngte Halbleiterelemente, die mit dem ersten Leitungstyp dotiert sind, wobei jedes Element auf einem der Anschlüsse oder der Schicht sitzt;
lichtemittierende Halbleiterteile (30; 72), wobei jeder Teil wenigstens teilweise eines der Halbleiterelemente abdeckt; und
einen Schaltkreis (S) zum Biasen der Anschlüsse (52) oder der Schicht, wobei das Substrat aus einem Halbleitermaterial aus der folgenden Gruppe aufweisend Silizium, Germanium, Siliziumcarbid, einem III-V Verbund, einem II-VI Verbund oder einer Kombination dieser Verbindungen ausgewählt wird, und wobei die Anschlüsse oder die Schicht aus einem Material hergestellt sind, die aus der Gruppe ausgewählt sind, die Aluminiumnitrid, Bornitrid, Siliziumcarbid, Magnesiumnitrid, Magnesium-Galliumnitrid oder eine Kombination aus diesen aufweist und von deren nitrierten Verbindungen.

2. Die optoelektronische Vorrichtung nach Anspruch 1, wobei die Vorrichtung ferner einen Schaltkreis (V+, V-) zum Biasen der Halbleiterteile (30; 72) aufweist.

3. Die optoelektronische Vorrichtung nach Anspruch 1 oder 2, wobei die Dotierungskonzentration der Anschlüsse (52) oder der Schicht im Bereich von 10¹⁵ Atome/cm³ bis 10¹⁹ Atome/cm³ liegt.

4. Die optoelektronische Vorrichtung nach einem der Ansprüche 1 bis 3, wobei die Dotierungskonzentration des Substrats (14) im Bereich von 10¹⁶ Atome/cm³ bis 10²¹ Atome/cm³ liegt.

5. Die optoelektronische Vorrichtung nach einem der Ansprüche 1 bis 4, wobei die Dotierungskonzentration von jedem Halbleiterelement (24) im Bereich von 10¹⁶ Atome/cm³ bis 10²¹ Atome/cm³ liegt.

6. Die optoelektronische Vorrichtung nach einem der Ansprüche 1 bis 5, wobei die Dicke von jedem Anschluss (52) oder der Schicht im Bereich von 1 nm bis 1 µm liegt.

7. Die optoelektronische Vorrichtung nach einem der Ansprüche 1 bis 6, wobei das Substrat (14) aus einem Einristall-Silizium gefertigt ist.

8. Die optoelektronische Vorrichtung nach einem der Ansprüche 1 bis 7, wobei jedes Halbleiterelement (24) im Wesentlichen ein Halbleitermaterial aufweist, das ausgewählt wird aus der Gruppe aufweisend einen III-V Verbund, einen II-VI Verbund oder eine Kombination aus diesen Verbindungen.

9. Die optoelektronische Vorrichtung nach einem der Ansprüche 1 bis 8, wobei jedes Halbleiterelement (24) ein Mikrodraht oder ein Nanodraht ist.

10. Die optoelektronische Vorrichtung nach einem der Ansprüche 1 bis 9, wobei jedes Halbleiterelement (24) wenigstens teilweise mit einer Halbleiterstruktur (30; 72) abgedeckt ist, die geeignet ist Licht zu emittieren.

11. Ein Verfahren zur Herstellung der optoelektronischen Vorrichtung (50; 70) gemäß einem der Ansprüche 1 bis 10, wobei das Verfahren die folgenden aufeinanderfolgenden Schritte aufweist:
Bereitstellen eines dotierten Halbleitersubstrats (14) eines ersten Leitungstyps;
Ausbilden, in Kontakt mit einer Oberfläche (16) des Substrats, einer Schicht oder von Anschlüssen (52), die mit einem zweiten Leitungstyp gegensätzlich zu dem ersten Typ dotiert sind;
Ausbilden von drahtförmigen (24), konischen oder verjüngten Halbleiterelementen, die mit dem ersten Leitungstyp dotiert sind, wobei jedes Element auf einem der Anschlüsse oder der Schicht sitzt;
Ausbilden von lichtemittierenden Halbleiterteilen (30; 72), wobei jeder Teil wenigstens teilweise eines der Halbleiterelemente abdeckt; und
Bereitstellen eines Schaltkreises (S) zum Biasen der Anschlüsse (52) oder der Schicht, wobei das Substrat aus einem Halbleitermaterial aus der folgenden Gruppe aufweisend Silizium, Germanium, Siliziumcarbid, einem III-V Verbund, einem II-VI Verbund oder einer Kombination dieser Verbindungen ausgewählt wird, und wobei die Anschlüsse oder die Schicht aus einem Material hergestellt sind, die aus der Gruppe ausgewählt sind, die Aluminiumnitrid, Bornitrid, Siliziumcarbid, Magnesiumnitrid, Magnesium-Galliumnitrid oder eine Kombination aus diesen aufweist und von deren nitrierten Verbindungen.

## Claims

1. An optoelectronic device (50; 70) comprising:
a doped semiconductor substrate (14) of a first conductivity type;
pads (52) or a layer, on a surface (16) of the substrate, doped with a second conductivity type opposite to the first type;
wire-shaped (24), conical, or tapered semiconductor elements, doped with the first conductivity type, each element resting on one of the pads or on the layer;
light-emitting semiconductor portions (30; 72), each portion at least partially covering one of the semiconductor elements; and
a circuit (S) for biasing the pads (52) or the layer,
wherein the substrate is made of a semiconductor material selected from the group comprising silicon, germanium, silicon carbide, a III-V compound, a II-VI compound, and a combination of these compounds, and wherein the pads or the layer are made of a material selected from the group comprising aluminum nitride, boron nitride, silicon carbide, magnesium nitride, magnesium gallium nitride, or a combination thereof and of their nitrided compounds.

2. The optoelectronic device of claim 1, further comprising a circuit (V+, V-) for biasing the semiconductor portions (30; 72).

3. The optoelectronic device of claim 1 or 2, wherein the dopant concentration of the pads (52) or of the layer is in the range from 10¹⁵ atoms/cm³ to 10¹⁹ atoms/cm³.

4. The optoelectronic device of any of claims 1 to 3, wherein the dopant concentration of the substrate (14) is in the range from 10¹⁶ atoms/cm³ to 10²¹ atoms/cm³.

5. The optoelectronic device of any of claims 1 to 4, wherein the dopant concentration of each semiconductor element (24) is in the range from 10¹⁶ atoms/cm³ to 10²¹ atoms/cm³.

6. The optoelectronic device of any of claims 1 to 5, wherein the thickness of each pad (52) or of the layer is in the range from 1 nm to 1 µm.

7. The optoelectronic device of any of claims 1 to 6, wherein the substrate (14) is made of single-crystal silicon.

8. The optoelectronic device of any of claims 1 to 7, wherein each semiconductor (24) element mainly comprises a semiconductor material selected from the group comprising a III-V compound, a II-VI compound, and a combination of these compounds.

9. The optoelectronic device of any of claims 1 to 8, wherein each semiconductor element (24) is a microwire or a nanowire.

10. The optoelectronic device of any of claims 1 to 9, wherein each semiconductor element (24) is at least partially covered with a semiconductor structure (30; 72) capable of emitting light.

11. A method of manufacturing the optoelectronic device (50; 70) according to any of claims 1 to 10, comprising the successive steps of:
providing a doped semiconductor substrate (14) of a first conductivity type;
forming, in contact with a surface (16) of the substrate, a layer or pads (52), doped with a second conductivity type opposite to the first type;
forming wire-shaped (24), conical, or tapered semiconductor elements, doped with the first conductivity type, each semiconductor element being in contact with one of the pads or the layer;
forming light-emitting semiconductor portions (30; 72), each portion at least partially covering one of the semiconductor elements; and
providing a circuit (S) for biasing the pads (52) or the layer,
wherein the substrate is made of a semiconductor material selected from the group comprising silicon, germanium, silicon carbide, a III-V compound, a II-VI compound, and a combination of these compounds and wherein the pads or the layer are made of a material selected from the group comprising aluminum nitride, boron nitride, silicon carbide, magnesium nitride, magnesium gallium nitride, or a combination thereof and of their nitrided compounds.
